# EUROPEAN PATENT APPLICATION

(11) **EP 2 822 370 A1**
(43) Date of publication of application: **07.01.2015**
(21) Application number: 13175366.7
(22) Date of filing: 05.07.2013
(51) Int. Cl.: H05K 5/06, H05K 7/20

(54) **Canister cooling**

(71) Applicant: Siemens Aktiengesellschaft, 80333 München (DE)
(72) Inventor: Volent, Kjetil Zsolt, 7022 Trondheim (NO); Kristiansen, Karstein, 7051 Trondheim (NO)

(57) **Abstract**

The present invention relates to a canister (100) for housing an electronic component (140). The canister (100) comprises a wall section with an inner wall surface which is directed to an inner volume (Vi) of the canister (100), wherein the inner wall surface comprises an air guiding structure with at least one air guiding channel (101) for guiding air inside the inner volume (Vi) along the inner wall surface.

## Description

### Field of invention

The present invention relates to a canister for housing an electronic component, wherein the canister comprises an air guiding structure.

### Art background

Electronic components are encapsulated inside closed and isolated canisters in order to protect the electronic components from destructive and harmful environmental fluids, such as saltwater.

Inside a closed canister, heat generated from the electronic components causes an increase of the inside temperature of the canister. This may cause a decrease in lifetime of the electronic components and an increase of the risk of a malfunction.

Hence, passive cooling devices are installed inside the canister in order to cool the electronic components.

### Summary of the Invention

It may be an object of the present invention to provide a canister for housing electronic components which comprises a proper cooling efficiency.

This object may be solved by a canister for housing an electronic component according to the independent claim. According to a first aspect of the present invention a canister for housing an electronic component is presented. The canister comprises a wall section with an inner wall surface which is directed to an inner volume of the canister. The inner wall surface comprises an air guiding structure with at least one air guiding channel for guiding air inside the inner volume along the inner wall surface.

The electronic components may be any type of an electrically driven device, such as a fuse, a computer, an integrated circuit, an electronic switch or any other electronic component. Hence, during operation of the electronic component, heat is generated.

The canister forms a hollow housing with an inner volume into which the electronic component and/or a plurality of electronic components, respectively, are installed. The canister is a sealed and isolated canister, such that an uncontrolled fluid exchange (such as air) between the inner volume and the environment of the canister is prevented. Such a canister for housing electronic components may be used for subsea applications where the canister is exposed to an aggressive medium, such as saltwater.

The canister may be a pressure resistant subsea canister. The canister may be adapted to be suitable for installation at a water depth of 1,000m or more, preferably 2,000 m or more, or even 3,000m or more. The canister may be filled with a gas. The canister may be configured to maintain a predefined internal pressure when installed subsea. Such predefined pressure may be a pressure below 5 bar, e.g. about or below 1.5 bar. The canister may be adapted to maintain atmospheric pressure inside, i.e. a pressure about 1 bar. In such configuration, standard electric and electronic components may be used inside the canister. The canister may further comprise penetrators or electrical through-connectors for contacting the electric or electronic components.

However, the canister may comprise additional interfaces, such as valve connections or other openings, through which an intentional exchange of fluid between the inner volume and the environment may be provided in a controlled manner.

The canister may comprise for example a cylindrical shape comprising a circle, elliptical or rectangular base.

The wall section of the canister defines a section (i.e. a region) to which the air guiding structure is formed. The air guiding structure comprises at least one air guiding channel. The air guiding channel is an open channel which comprises an open side along its length extension e.g. to the inner volume. The air guiding channel may be formed by fins (intrusive design) or by a respective groove/slot (non-intrusive design) as described more in detail below. In other words, the air in the inner volume may enter the air guiding channel along the whole length of the air guiding channel. In other words, the air guiding channel is not a closed air guiding channel comprising an air inlet and an air outlet at its end sections. The air guiding channel has for example an open U-shaped cross-section.

Hence, the air flowing (streaming) inside the inner volume of the canister may flow against the wall section and may then be further guided to a desired destination by the air guiding channel of the air guiding structure. Specifically, the canister is mounted to a mounting wall or is located close to a mounting wall at its place of operation. For example, the canister is mounted to a mounting wall of a nacelle of a wind turbine, in an exemplary embodiment. Hence, a first wall section of the canister which is located close to the mounting wall has a different temperature than other second wall sections of the canister which are further spaced apart from the mounting wall, for example. Hence, the convection between the inner volume of the first and second wall section of the canister differs, such that also the air temperature inside the inner volume differs between different locations inside the inner volume. Due to the different temperatures of the air inside the inner volume, an airflow caused by the thermal effect generated by the different temperatures of the air inside the inner volume occurs. Due to the air guiding structure with at least one air guiding channel, the airflow is directed along the wall section to a desired location such that the cooling effect may be increased. Furthermore, the air guiding channel of the air guiding structure increases the surface of the air guiding structure, such that the convection and i.e. the convection cooling is increased.

According to a further exemplary embodiment, the canister comprises a main body which surrounds the inner volume, wherein the main body comprises an opening. Furthermore, the canister comprises a lid which is coupled to the main body for covering the opening, wherein the wall section forms part of the main body and/or the lid.

Hence, by the exemplary embodiment it is outlined, that the air guiding structure and hence at least one of the air guiding channels is formed along an inner surface of the main body, which may form the shell of the canister, and/or along the inner surface of the lid, which may be an end face of the canister, e.g. a top lid or a bottom lid of the canister.

According to a further exemplary embodiment of the present invention, the wall section forms part of the lid, wherein the air guiding structure comprises a plurality of air guiding channels. Each of the air guiding channels may run parallel with respect to each other. Alternatively, according to a further exemplary embodiment of the present invention, the air guiding channels are spaced apart from each other, wherein at least some of the air guiding channels run from a centre region of the lid to a circumferential end of the lid.

The centre region of the lid may for example a region, through which the symmetry axis of the main body runs. Hence, the air may flow against the inner wall surface of the lid and is further guided by the air guiding channels from the centre region to the circumferential region.

According to a further exemplary embodiment of the present invention, the wall section forms part of the main body, wherein the air guiding structure comprises a plurality of air guiding channels. At least some of the air guiding channels may run parallel with respect to each other, e.g. between a bottom and a top end (opening of the main body) of the canister. Alternatively, according to a further exemplary embodiment of the present invention, the air guiding channels are spaced apart from each other, wherein at least some of the air guiding channels run from a common region at the inner surface to the opening of the main body. Alternatively, the common region is located at the opening of the main body and the air guiding channels run from the common region along the inner wall surface of the main body away from the common region.

In an exemplary embodiment, the air guiding channels run from the common region to the opening of the main body, wherein the air guiding channels run with a helical run along the inner wall surface of the main body to the opening. Hence, the air may flow against the common region of the inner wall surface and may be guided further through the air guiding channels to the opening or the air may be guided from the opening to the common region.

According to a further exemplary embodiment, the at least one air guiding channel is formed by a groove within the inner wall surface. The groove comprises an open profile, such as a U-shaped or V-shaped profile.

According to a further exemplary embodiment, the at least one air guiding channel or at least some of the air guiding channels is formed by at least one fin arranged at the inner wall surface. Specifically, two spaced apart fins may form an air guiding channel between each other. The fins may be integrally formed with the inner wall surface. Furthermore, the fins may be welded, braised or glued onto the inner wall surface.

The fins may be made of metal or other material which comprises a proper heat conducting characteristic.

According to a further exemplary embodiment, the at least one air guiding channel comprises a longitudinal extension. Hence, for example a plurality of air guiding channels may comprise a parallel run with respect to each other.

According to a further exemplary embodiment, the at least one air guiding channel comprises a curved, non-longitudinal extension.

Moreover, in a further exemplary embodiment, the air guiding channels may comprise longitudinal and curved extensions with respect to each other. Moreover, an air guiding channel may comprise along its length a curved and a longitudinal extension.

According to a further exemplary embodiment, the at least one air guiding channel is formed such that the at least one air guiding channel is a diffusor with an increasing flow diameter along a flow direction of the air. In other words, the at least one air guiding channel comprises an increasing flow diameter between two opposed ends of the air guiding channel.

According to a further exemplary embodiment, the at least one air guiding channel is formed such that the at least one air guiding channel is a nozzle with a reducing flow diameter along a flow direction of the air. In other words, the at least one air guiding channel comprises an increasing flow diameter between two opposed ends of the air guiding channel.

According to a further exemplary embodiment, the canister further comprises an inner housing which is arranged within the inner volume. The inner housing is arranged with respect to the main body in such a way
that the first main flow channel for the air is formed between the inner wall surface and the inner housing and
that the second main flow channel for the air is generated within the inner housing. The inner housing comprises a first opening and a second opening. The air is flowable between the first main flow channel and the second main flow channel through the respective first opening and second opening. The first opening is arranged closer to the lid than the second opening.

By the present exemplary embodiments, a directed air circulation of the air flowing through the first main flow channel and the second main flow channel is generated. For example, the air flows through the first main flow channel along a first direction and the air flows through the second main flow channel along a second direction, wherein the first direction and the second direction are opposed with respect to each other.

Specifically, the circulation of the air through the first main flow channel and the second main flow channel may be driven by thermal effects. For example, cooler air flowing through the first main flow channel may flow from the top to a bottom of the canister, wherein the hotter air flowing through the second main flow channel may flow from the bottom to the top of the canister. The first main flow channel which is formed between the inner wall surface and the inner housing may be in contact with the air guiding structure formed along the inner wall surface of the main body. Hence, convection cooling in the first main flow channel is increased.

Additionally, a further air guiding structure comprising at least one further air guiding channel may be formed along an inner surface or an outer surface of the inner housing. The inner housing comprises a further inner volume, which forms the second main flow channel. The electrical components may be fixed and mounted to the inner housing, for example.

According to a further exemplary embodiment, the canister comprises a fan for guiding the air to the at least one air guiding channel. Hence, in order to generate an air circulation inside the inner volume, the fan may be used. Hence, a convection cooling is increased.

According to a further exemplary embodiment, the canister comprises a cooling device which is coupled to the wall section for cooling the at least one air guiding channel.

In some embodiments, the wall section comprising the air guiding structure may form part of the lid and the main body, so that a plurality of air guiding channels can be provided in both the lid and the main body. The respective air guiding channels can have any configuration as described herein, and any combination of the configurations of the air guiding channels in the lid and the air guiding channels in the main body is conceivable and may form part of embodiments.

Hence, by the present invention and in particular by the above described air guiding structure the hot air inside the inner volume of the canister can be forced and controlled to flow along a certain desired direction to maximise the effect of natural convection. Increasing the convection cooling effect, the electrical components inside the canister are cooler and the lifetime is increased.

It has to be noted that embodiments of the invention have been described with reference to different subject matters. In particular, some embodiments have been described with reference to apparatus type claims whereas other embodiments have been described with reference to method type claims. However, a person skilled in the art will gather from the above and the following description that, unless otherwise notified, in addition to any combination of features belonging to one type of subject matter also any combination between features relating to different subject matters, in particular between features of the apparatus type claims and features of the method type claims is considered as to be disclosed with this application.

### Brief Description of the Drawings

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.
Fig.1 shows a section of the canister comprising a lid with an air guiding structure comprising air guiding channels which are formed by fins according to an exemplary embodiment of the present invention,
Fig.2 shows a detailed view of a lid comprising fins according to an exemplary embodiment of the present invention,
Fig.3 shows a section of a canister comprising a lid with the air guiding structure comprising the air guiding channels which are formed by slots according to an exemplary embodiment of the present invention,
Fig.4 shows a detailed view of a lid comprising slots according to an exemplary embodiment of the present invention,
Fig.5 shows a section of a canister comprising a lid with curved air guiding channels and a main body with curved air guiding channels, wherein the air guiding channels are formed by slots, according to an exemplary embodiment of the present invention,
Fig.6 shows a section of a canister comprising a lid with curved air guiding channels and a main body with straight longitudinal air guiding channels, wherein the air guiding channels are formed by slots, according to an exemplary embodiment of the present invention,
Fig.7 shows a schematic view of a canister with a lid comprising straight cooling channels formed by fins, according to an exemplary embodiment of the present invention,
Fig.8 shows the canister shown in Fig.7, wherein in Fig.8 the air flow direction according to an exemplary embodiment of the present invention is shown,
Fig.9 shows a schematic view of a section of a main body comprising curved air guiding channels according to an exemplary embodiment of the present invention,
Fig.10 shows a perspective view of a main body of the canister comprising parallel air guiding channels according to an exemplary embodiment of the present invention,
Fig.11 shows a schematic view of a cross section of a main body of the canister according to an exemplary embodiment of the present invention,
Fig.12 shows a perspective view of a lid of a canister comprising a plurality of fins forming a plurality of air guiding channels according to an exemplary embodiment of the present invention, and
Fig.13 shows a perspective view of a canister according to an exemplary embodiment of the present invention.

### Detailed Description

The illustrations in the drawings are schematic. It is noted that in different figures similar or identical elements are provided with the same reference signs.

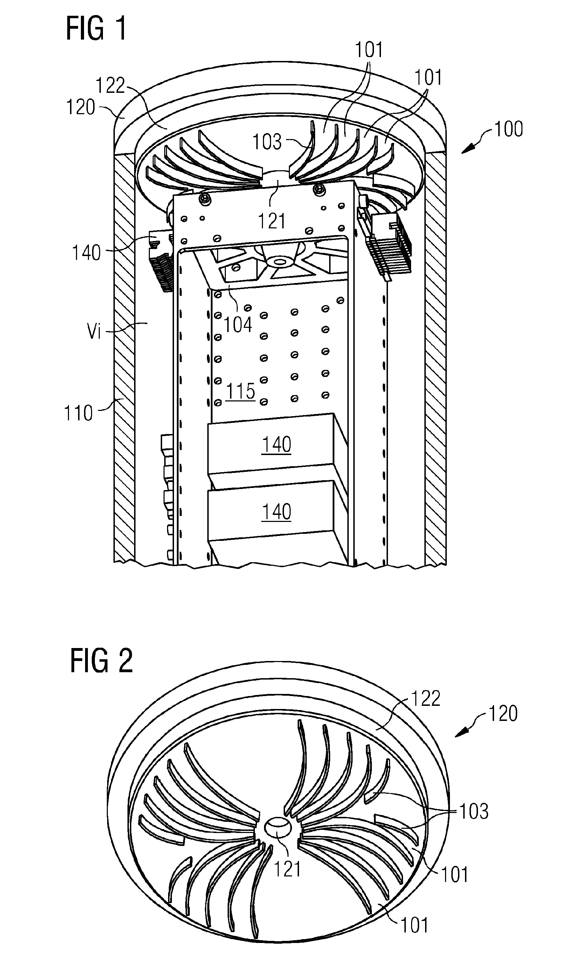

Fig.1 shows a canister 100 for housing electronic components 140. The canister 100 comprises a wall section with an inner wall surface which is directed to an inner volume Vi of the canister 100. The inner wall surface comprises an air guiding structure with a plurality of air guiding channels 101 for guiding the air inside the inner volume Vi along the inner wall surface. According to the exemplary embodiment shown in Fig.1, the air guiding channels 101 are formed at a lid 120 of the canister 100.

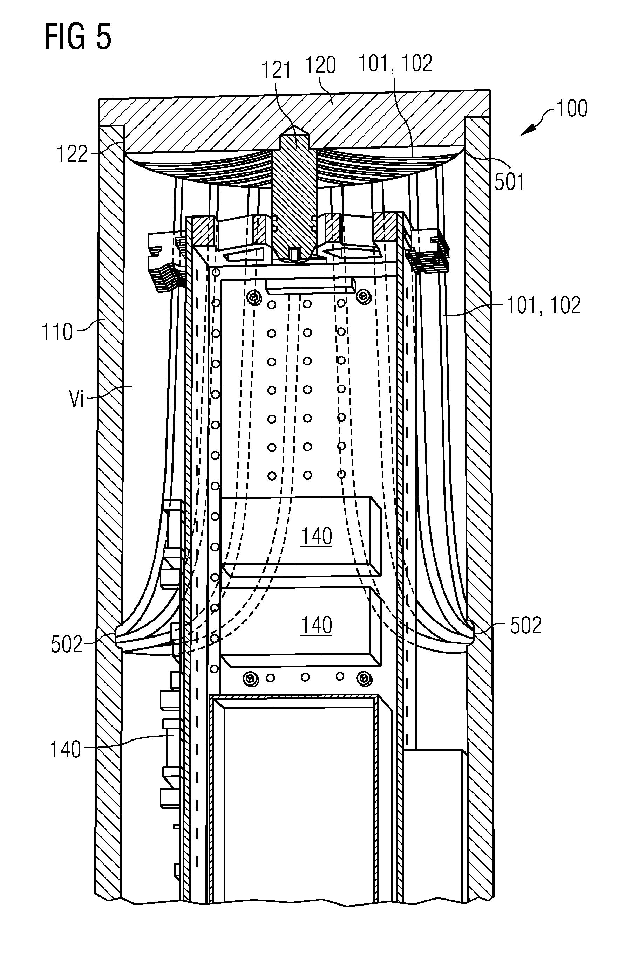

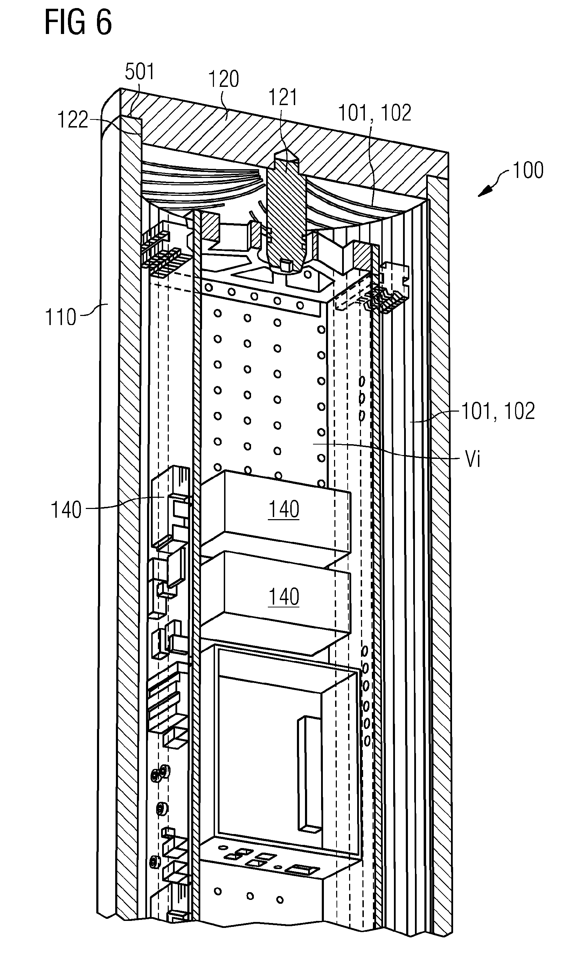

In particular, the canister 100 comprises a main body 110 which surrounds the inner volume Vi, wherein the main body 110 comprises an opening 502 (see Fig.5). The lid 120 is coupled to the main body 110 for a covering the opening 502. The wall section comprising the air guiding structure may be formed to an inner surface of the main body 110, to an inner surface of the lid 120 (see e.g. Fig.1) or to both, the inner surfaces of the main body 110 and the lid 120 (see e.g. Fig.5 and Fig.6).

An inner housing 115 is arranged inside the inner volume Vi of the main body 110. The inner housing 115 may form a supporting structure for various electronic components 140, such as electronic fuses, integrated circuits or other heat generating electronic devices. The air inside the inner volume Vi circulates around the electronic components 140 and hence the air is heated up by the hot electronic components 140 during operation of the electronic components 140.

The canister 100 may be mounted to a mounting wall of a mounting structure. Hence, the wall sections of the canister 100 which are close to the mounting wall may be hotter or colder than the other wall sections of the canister 100. Hence, natural convection between the inner volume Vi and the environment causes different air temperatures inside the inner volume Vi and hence causes an air circulation generated by e.g. thermic effects.

The air guiding channels 101 which are formed in the exemplary embodiment in Fig.1 by curved fins 103 guide the air from a centre region 121 to a circumferential end 122 of the lid 120 or vice versa. Specifically, the air guiding channels 101 guide the air to a circumferential end 122 which is located close to a colder mounting wall of a supporting structure such that convection cooling is increased.

The fins 103 are curved and run from the central region 121 to the circumferential end 122. Thereby, the distance between adjacent fins 103 differs. For example, as shown in Fig.1, the distance between two adjacent fins 103 increases along an extension from the centre region 121 to the circumferential end 122. Hence, the air guiding channel 101 and its flow diameter increases from the centre region 121 to the circumferential end 122. The increasing flow diameter of the air guiding channel 101 forms a diffusor for an air flowing from the centre region 121 to the circumferential end 122. Alternatively, for an air which flows from the circumferential end 122 to the centre region 121, the air guiding channel 101 which is formed between two adjacent fins 103 at the inner surface of the lid 120 forms a nozzle for the air.

Hence, the airflow may be controlled such that the air flows to a desired wall section of the main body 110. In some cases, the canister 110 is fasted in such a way that one or more sides of the canister 100 are exposed to hot or cold elements. The natural convection inside the canister 100 will be more effective if the outside temperature is kept low. If this is not possible around the whole canister 100, the airflow inside the inner volume Vi of the canister 100 is directed towards the areas where the canister 100 is cool, making the natural convection inside the canister 100 as effective as possible.

Furthermore, by the air guiding channels 101, the area of the inner lid surface and of the inner main body surface may be increased. The fins 103 may act as cooling fins in particular if the fins 103 are made of a material with good heat conducting characteristics.

Furthermore, in order to control the air circulation inside the inner volume Vi, the canister 100 may comprise a fan 104 for generating the desired air circulation.

Fig.2 shows the lid 120 shown in Fig.1. As can be seen in Fig.2, the fins 103 have a curved extension and guide the air for example from the centre section 121 to the circumferential end 122 of the lid 120. For the air which flows from the centre region 121 to the circumferential end 122, the guiding channels 101 which are formed between the fins 103 may function as a diffusor.

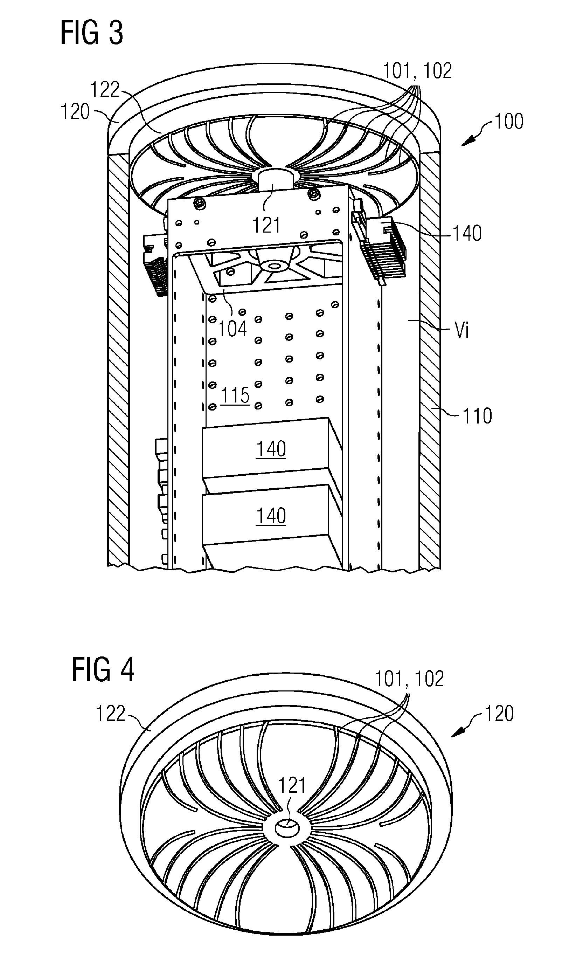

Fig.3 shows a canister 100 comprising similar features as the canister 100 shown in Fig.1. In contrast to the lid 120 as shown in Fig.1, the lid 120 shown in Fig.3 comprises a plurality of grooves 102 or slots which run from the centre section 121 to the circumferential end 122. The grooves 102 form the air guiding channels 101 for guiding the air between the circumferential end 122 and the centre section 121 of the lid 120. The grooves 102 may form a U-shaped or V-shaped open profile, for example.

Fig.4 shows the lid 120 shown in Fig.3. As can be seen in Fig.4, the grooves 102 have a curved extension and guide the air for example from the centre section 121 to the circumferential end 122 of the lid 120. The grooves 102 may also comprise a varying flow diameter (cross section) along its extension from the centre region 121 to the circumferential end 122 of the lid 120.

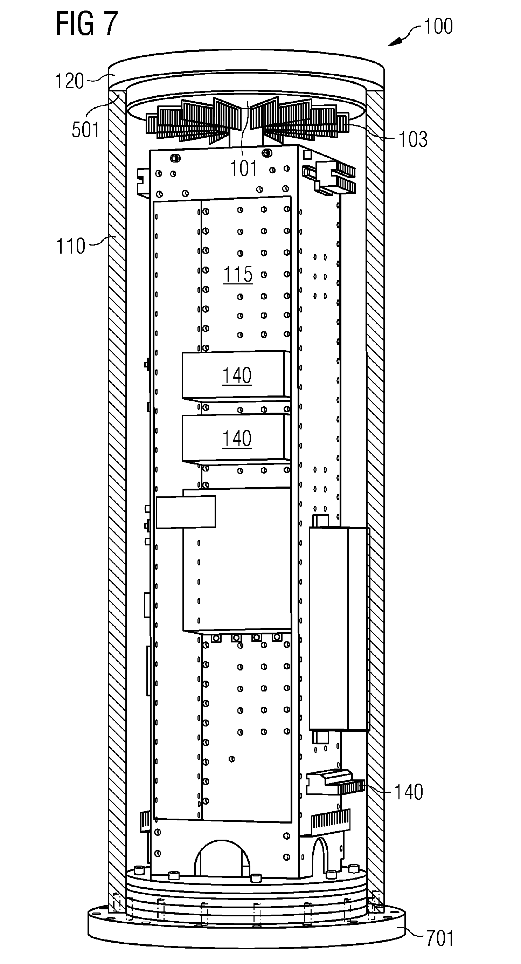

Fig.5 shows a canister 100 comprising similar features as the canister 100 shown in Fig.3. Additionally, the air guiding channels 101 are formed by grooves 102 formed within an inner surface of the main body 110 of the canister 100. In Fig.5, the grooves 102 run from a common region 502 along the main body 110 to the opening 502 of the main body 110. For example, the air which is guided by the grooves 102 from the centre region 121 to a circumferential end 122 of the lid 120 may further flow from the lid 120 along the grooves 101 formed within the main body 110 to the common region 502. The air cools down while flowing from the centre region 121 to the circumferential end 122 and further to the common region 502 due to convection cooling. Because the inner surface wall cools down the air, the air flows from the top lid 120 along the main body 110 in the direction to the bottom 701 (see Fig. 7) of the main body 110 due to thermic effects.

The air guiding channels 101 formed in the main body 110 and formed in the lid 120 may also be formed between respective fins 103 which may be arranged at the respective inner surface of the main body 110 and/or the lid 120.

Fig.6 shows a canister 100 comprising similar features as the canister 100 shown in Fig.3 and in Fig.5. In contrast to the canister 100 shown in Fig.5, the canister 100 shown in Fig.6 comprises grooves 102 running along the inner surface of the main body 110, wherein the grooves 102 are formed parallel with respect to each other.

Fig.7 shows a canister 100 comprising similar features as the canister 100 shown in Fig.1. In contrast to the canister 100 shown in Fig.1, the canister 100 shown in Fig.7 comprises fins 103 which have a straight and longitudinal extension. Furthermore, the fins 103 may comprise a plurality of cutouts in order to increase its cooling surface. In other words, the fins 103 may have a comb-shaped design. Furthermore, the bottom 701 of the canister 100 is indicated. The bottom 701 may be formed at a further opening of the main body 110, wherein the further opening is arranged at an opposite end of the main body 110 with respect to the opening 501. The bottom 701 may also comprise further air guiding channels formed by grooves or fins as described for the lid 120.

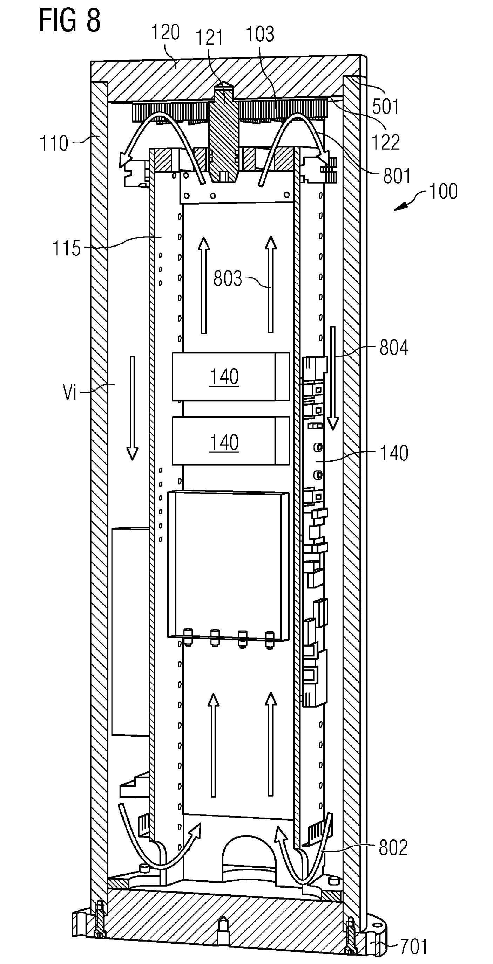

Fig.8 shows a canister 100 comprising similar features as the canister 100 shown in Fig.7. Additionally, an exemplary air circulation inside the inner volume Vi is indicated by arrows. Inside the hollow inner housing 115 the air heats up due to the hot electronic components 140 and streams up to the lid 120. From the centre region 121 of the lid 120 the air is guided by air guiding channels 101 which are formed between adjacent fins 103 to the circumferential end 122 of the lid 120. Thereby, the air cools due to a convection cooling. At the circumferential end 122 of the lid 120 the cooled air streams due to thermic effects down to the bottom 701 of the canister 100.

The inner housing 115 is arranged within the inner volume Vi in such a way that a first main flow channel 803 for the air is formed between the inner wall surface of the main body 110 and the inner housing 115 and that a second main flow channel 804 for the air is generated within the hollow inner housing 115. At the upper and of the inner housing 115 a first opening 801 is formed such that the air may flow between the first and second main flow channels 803, 804. At the bottom 701 the inner housing 115 a second opening 802 such that the air may flow between the first main flow channel 803 and the second main flow channel 804.

The air flows for example through the second main flow channel 804 from the lid 120 to the bottom 701. Additionally, further air guiding channels 101 may be formed to the inner surface of the main body 110 and/or the outer surface of the inner housing 115 in order to guide the air down to the bottom 701 and in order to increase the surface area for increasing the convection cooling. Inside the further inner volume Vi of the inner housing 115 the air heats up due to the hot electronic components 140 and streams again up to the lid 120. Hence, due to the thermic effects a self generated air circulation inside the inner volume Vi of the canister 100 is generated.

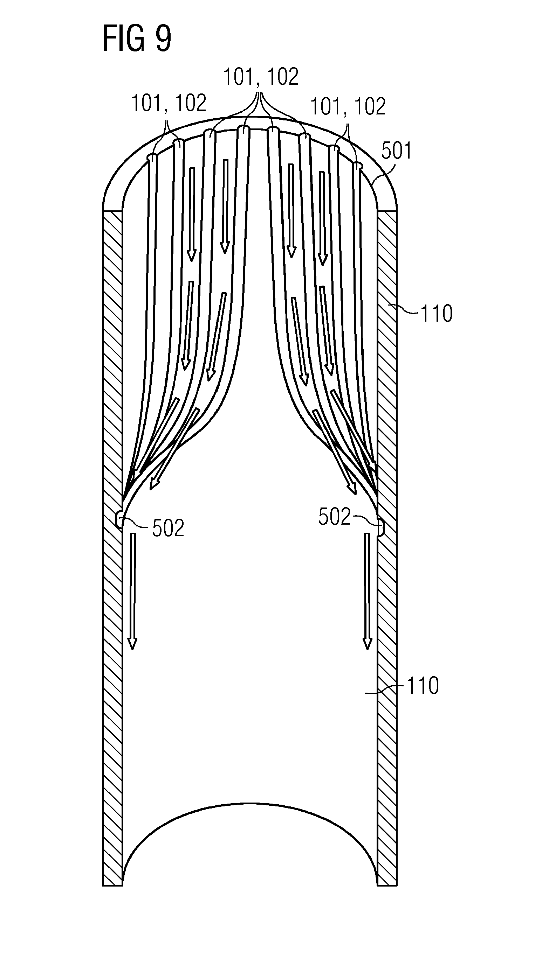

Fig.9 shows an exemplary embodiment of a section of the inner surface of the main body 110. In the exemplary embodiment shown in Fig.9, air guiding channels 101 are formed by grooves 102. The grooves 102 comprise a U-shaped cross-section. Furthermore, the grooves 102 comprise a curved and helical/spiral run along the inner surface of the main body 110. The grooves 102 run from the opening 501 of the main body 110 to a common region 502. In the common region 502, the grooves 102 merge with each other. Hence, the air flowing through the air guiding channels 101 is forced towards the common region 502. The common region 502 is formed at a desired region of the canister wall, at which the canister wall generally comprises the coldest spots in order to improve the convection cooling. While travelling along the inner surface, the air is cooled.

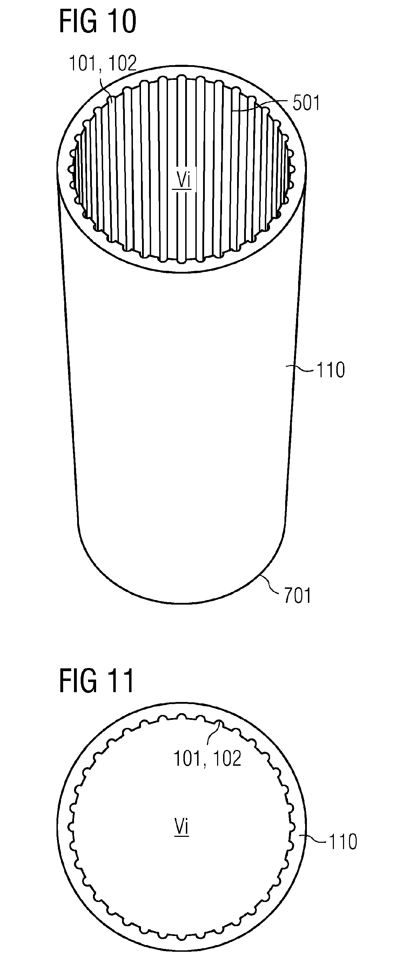

Fig.10 shows a perspective view of a main body 110. The main body 110 comprises parallel grooves 102 which form the air guiding channels 101. The parallel grooves 102 run from the opening 501 to the bottom 701.

Fig.11 shows a cross-sectional view of the main body 110 shown in Fig.10. As can be taken from the cross-sectional view in Fig.11, the grooves 102 increases the inner surface of the wall of the main body 110. Hence, the convection cooling is increased by forming the slots/grooves 102.

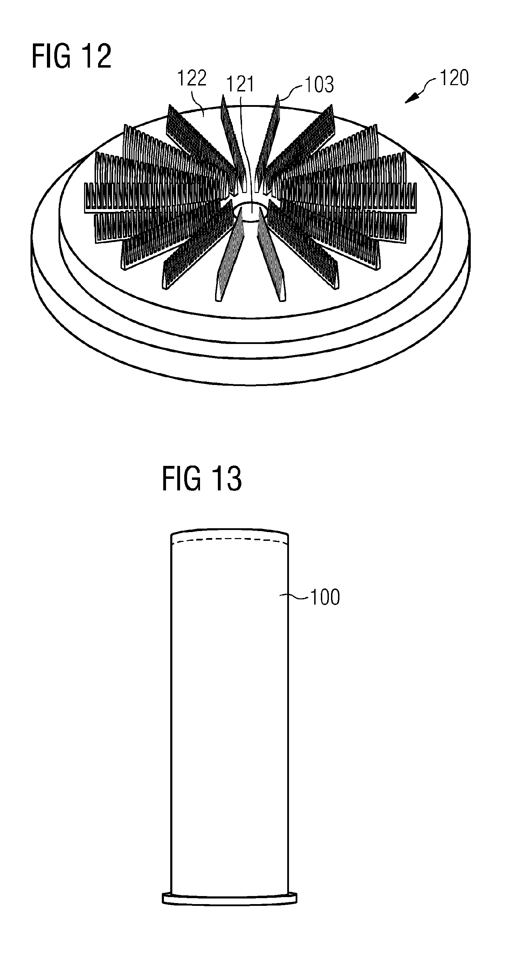

Fig.12 shows a perspective view of the lid 120 which comprises fins 103 which are mounted to an inner surface of the lid 120. The fins 103 run from a centre region 121 to a circumferential end 122 of the lid 120. The fins 103 comprise a comb-shaped design.

Fig.13 shows a perspective view of a canister 100 according to an exemplary embodiment of the present invention. Additionally, additional connection cables, such as jumper cables or power supply cables, which are not shown in Fig.13, may run inside the inner volume Vi of the canister 100.

In the figures, for sake of clarity, not all identical features are assigned with a respective reference signs. For the skilled person it is clear which features in the drawings are assigned to one common group of features, such as the air guiding channels 101 or the fins 103.

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

## Claims

1. Canister (100) for housing an electronic component (140), the canister (100) comprising
a wall section with an inner wall surface which is directed to an inner volume (Vi) of the canister (100), wherein the inner wall surface comprises an air guiding structure with at least one air guiding channel (101) for guiding air inside the inner volume (Vi) along the inner wall surface.

2. Canister (100) according to claim 1, further comprising
a main body (110) which surrounds the inner volume (Vi), wherein the main body (110) comprises an opening (502), and
a lid (120) which is coupled to the main body (110) for covering the opening (502),
wherein the wall section forms part of the main body (110) and/or the lid (120).

3. Canister (100) according to claim 2,
wherein the wall section forms part of the lid (120), wherein the air guiding structure comprises a plurality of air guiding channels (101).

4. Canister (100) according to claim 3,
wherein the air guiding channels (101) are spaced apart from each other, and
wherein each of the air guiding channels (101) run from a centre region (121) of the lid (120) to a circumferential end (122) of the lid (120).

5. Canister (100) according to claim 2,
wherein the wall section forms part of the main body (110), wherein the air guiding structure comprises a plurality of air guiding channels (101).

6. Canister (100) according to claim 5,
wherein the air guiding channels (101) are spaced apart from each other and run along the inner surface of the main body (110) to the opening (502) of the main body (110).

7. Canister (100) according to claim 6,
wherein the air guiding channels (101) run from a common region (501) at the inner surface to the opening (502) of the main body (110).

8. Canister (100) according to one of the claims 1 to 7, wherein the at least one air guiding channel (101) is formed by a groove (102) within the inner wall surface.

9. Canister (100) according to one of the claims 1 to 8, wherein the at least one air guiding channel (101) is formed by at least one fin (103) arranged at the inner wall surface.

10. Canister (100) according to one of the claims 1 to 9, wherein the at least one air guiding channel (101) comprises a longitudinal extension.

11. Canister (100) according to one of the claims 1 to 10, wherein the at least one air guiding channel (101) comprises a curved extension.

12. Canister (100) according to one of the claims 1 to 11, wherein the at least one air guiding channel (101) is formed such that the at least one air guiding channel (101) is a diffusor with an increasing flow diameter along a flow direction of the air.

13. Canister (100) according to one of the claims 1 to 12, wherein the at least one air guiding channel (101) is formed such that the at least one air guiding channel (101) is a nozzle with an reducing flow diameter along a flow direction of the air.

14. Canister (100) according claim 2, further comprising
an inner housing (115) which is arranged within the inner volume (Vi),
wherein the inner housing (115) is arranged with respect to the main body (110) in such a way
that a first main flow channel (803) for the air is formed between the inner wall surface and the inner housing (115) and
that a second main flow channel (804) for the air is generated within the inner housing (115),
wherein the inner housing (115) comprises a first opening (801) and a second opening (802),
wherein air is flowable between the first main flow channel (803) and the second main flow channel (804) through the respective first opening (801) and second opening (802), wherein the first opening (801) is arranged closer to the lid (120) than the second opening (802).

15. Canister (100) according to one of the claims 1 to 14, further comprising
a fan (104) for guiding the air through the at least one air guiding channel (101).

16. Canister (100) according to one of the claims 1 to 15, further comprising
a cooling device which is coupled to the wall section for cooling the at least one air guiding channel (101).
